(19) **Europäisches Patentamt**
**European Patent Office**
**Office européen des brevets**

(11) **EP 1 745 532 B1**

(12) **EUROPEAN PATENT SPECIFICATION**

(45) Date of publication and mention
of the grant of the patent:
**15.08.2012 Bulletin 2012/33**

(51) Int Cl.:
***H01S 5/14*** *(2006.01)*

(21) Application number: **05732666.2**

(22) Date of filing: **25.04.2005**

(86) International application number:
**PCT/IB2005/001096**

(87) International publication number:
**WO 2005/104316 (03.11.2005 Gazette 2005/44)**

(54) **STABILIZED LASER SOURCE WITH VERY HIGH RELATIVE FEEDBACK AND NARROW BANDWIDTH**

STABILISIERTE LASERQUELLE MIT SEHR HOHER RELATIVER RÜCKKOPPLUNG UND SCHMALER BANDBREITE

Source laser stabilisée à retroaction relative très elevée et largeur de bande étroite

(84) Designated Contracting States:
**AT BE BG CH CY CZ DE DK EE ES FI FR GB GR HU IE IS IT LI LT LU MC NL PL PT RO SE SI SK TR**

(30) Priority: **27.04.2004 GB 0409272**

(43) Date of publication of application:
**24.01.2007 Bulletin 2007/04**

(73) Proprietor: **Oclaro Technology PLC**
**Caswell**
**Towcester**
**Northamptonshire NN12 8EQ (GB)**

(72) Inventors:
• **MOHRDIEK, Stefan**
**CH-8806 Baech (CH)**
• **PLISKA, Tomas**
**CH-8915 Hausen/Albis (CH)**
• **MATUSCHEK, Nicolai**
**CH-8047 Zürich (CH)**

(74) Representative: **Barth, Carl Otto et al**
**ABACUS Patentanwälte**
**Klocke Späth Barth**
**Zürichstrasse 34**
**8134 Adliswil/Zürich (CH)**

(56) References cited:
| EP-A- 0 991 153 | EP-A- 1 087 479 |
| --- | --- |
| EP-A- 1 130 717 | WO-A-96/18132 |
| WO-A-2004/073124 | US-A- 5 715 263 |
| US-A- 5 870 417 | US-A1- 2002 136 254 |
| US-A1- 2003 081 639 | US-B1- 6 215 809 |
| US-B1- 6 525 872 | |

• **HASHIZUME N ET AL: "Mode hopping control and lasing wavelength stabilization of fiber grating lasers" FURUKAWA REV; FURUKAWA REVIEW APRIL 2001, no. 20, April 2001 (2001-04), pages 7-10, XP002338313 cited in the application**
• **ARCHAMBAULT J-L ET AL: "FIBER GRATINGS IN LASERS AND AMPLIFIERS" JOURNAL OF LIGHTWAVE TECHNOLOGY, IEEE. NEW YORK, US, vol. 15, no. 8, August 1997 (1997-08), pages 1378-1390, XP000720461 ISSN: 0733-8724**

**Description**

**Field of the Invention**

This invention relates to the stabilization of a laser source, specifically a semiconductor laser diode of the type commonly used in opto-electronics, mostly as so-called pump lasers for fiber amplifiers in the field of optical communication. Erbium-doped fiber amplifiers are a prominent example using such laser diodes. Usually, such laser sources are designed to provide a relatively narrow-bandwidth optical radiation with a stable power output in a given frequency band. In particular, the invention relates to a laser using external reflector means providing very high relative feedback with a narrower bandwidth compared to conventional devices and in addition extremely low noise operation, even without an active temperature stabilizing element. Another advantage of the invention is the reduction of spectral distortions, in the case that polarization maintaining fiber is used. Such a laser source can also be used in different applications like frequency doubling systems, where effectiveness depends critically on a narrow spectral range and where noise requirements are stringent.

**Background and Prior Art**

Semiconductor laser diodes of the type mentioned above have, for example, become important components in the technology of optical communication, particularly because such laser diodes can be used for amplifying optical signals immediately by optical means. This allows the design of all-optical fiber communication systems, avoiding complicated conversions of the signals to be transmitted. The latter improves speed as well as reliability within such communication systems.

In one kind of optical fiber communication systems, the laser diodes are used for pumping erbium-doped fiber amplifiers, so-called EDFAs, which have been described in various patents and publications known to the person skilled in the art. An example of some technical significance is 980 nm lasers with a power output of 100 mW or more, which wavelength matches the 980 nm erbium absorption line and thus achieves a low-noise amplification. InGaAs laser diodes have been found to serve this purpose well and are used today in significant numbers. However, the invention is not limited to InGaAs laser diodes, but may also be used for other types as explained below.

Generally, laser diode pump sources used in fiber amplifier applications operate in the single transversal and vertical mode for efficient coupling into single-mode fibers and are mostly multiple longitudinal mode lasers, i.e. Fabry-Perot (FP) lasers. Three main types of laser diodes are typically used for erbium amplifiers, corresponding to the absorption wavelengths of erbium: InGaAsP and multiquantum-well InGaAs lasers are used at 1480 nm; strained quantum-well InGaAs lasers at 980 nm; and GaAlAs lasers at 820 nm.

Some fiber amplifier configurations require a defined polarization state of the light coming from the pump laser. Hence, depending on the application, pump sources are build with a polarization maintaining fiber to serve this particular requirement. Alternatively and less costly, a non-polarization maintaining fiber may be used, with similar pump source performance.

One of the problems occurring when using semiconductor laser diodes for the above purpose is their wavelength and power output instability which, though small, still affects the amplification sufficiently that there is motivation to look for a solution to the problem.

This problem is already addressed in US patent 5 563 732 by Erdogan et al., entitled "Laser Pumping of Erbium Amplifier", which describes the stabilization of a pump laser of the type described above by use of a Bragg grating in front of the laser diode. This grating provides an "external cavity" between the front facet of the laser diode and the grating in addition to the "laser cavity" or "active cavity" of the laser diode. The laser's emission spectrum is stabilized by the reflection from the grating. The grating is formed inside the guided-mode region of the optical fiber at a certain distance from the laser diode. Such a fiber Bragg grating is a periodic (or aperiodic) structure of refractive index variations in or near the guided-mode portion of the optical fiber, which variations are reflecting light of a certain wavelength propagating along the fiber. The grating's peak-reflectivities and reflection bandwidths determine the amount of light reflected back into the laser diode.

Ventrudo et al. US patent 5 715 263, entitled "Fibre-grating-stabilized Diode Laser" describes an essentially similar approach for providing a stabilized laser, showing a design in which the laser light is coupled to the fiber by focussing it through a fiber lens. Again, a fiber Bragg grating is provided in the fiber's guided mode portion, providing a significant external cavity and reflecting part of the incoming light back through the lens to the laser. To be precise, this lens will usually have a finite reflectivity and additional cavities are thus formed between this reflector and other reflecting surfaces. However, these reflections are considered as being negligible.

Now, when positioning a fiber Bragg grating at a certain distance from the laser diode's front facet and when the laser diode's gain peak is not too far from the Bragg grating's center wavelength, it is understood that the laser diode is forced to operate within the optical bandwidth of the grating and thus is wavelength stabilized. Additionally, low-frequency power fluctuations seem to decrease by the effect of induced high-frequency multi-mode operation. In this prior art, multiple modes of the "main" or dominant cavity, which is formed between the laser's front facet and its back facet, are generated within the wavelength range defined by the fiber Bragg grating bandwidth. In the following, these modes are referenced as "laser longitudinal modes".

Though the above stabilization methods are effective, they all use active temperature stabilizing elements. None of the above prior art addresses solutions for high power (i.e. > 100 mW) laser sources, capable of stable operation without using an active temperature stabilizing element. Such cooling elements, commonly known as thermoelectric coolers (TEC), are usually attached to the heatsink of the laser diode for maintaining the laser temperature at a constant level. The need for TEC's contributes significantly to the complexity and cost of a laser source.

Further unaddressed is a wavelength stabilization to a narrow bandwidth, i.e. a bandwidth which can be substantially narrower then the wavelength separation between the laser longitudinal modes.

In a paper about fiber grating lasers (FGL) by Hashizume et al., entitled "Mode Hopping Control and Lasing Wavelength Stabilization of Fiber Grating Lasers", published in the Furukawa Review, No. 20, 2001, the authors describe the use of a very low front facet reflectivity of a laser diode to reduce or eliminate the so-called mode hopping of a laser source. The paper describes a theoretical investigation of the mode hopping phenomenon, using a full-width-half-maximum (FWHM) bandwidth of the Bragg grating of 100 pm, and a reflectivity of the laser diode's front facet of 0.01 %. The paper also addresses the use of relatively large distances between the laser diode and the Bragg grating, mentioning that a distance larger than 10 cm yields a tolerable wavelength deviation of 0.1 nm. Two approaches to control the inherent mode hopping are shown; both rely on very precise temperature control. But neither the question of very low noise is addressed, nor are very large distances, e.g. of 1 m and more, between the laser diode and the Bragg grating discussed.

The application of grating stabilized laser diodes for frequency doubling is described in a paper by Kozlovsky et al., entitled "Blue Light Generation by Resonator-enhanced Frequency Doubling of an Extended-cavity Diode Laser", published in Applied Physics Letters, 1994. A diffraction grating is used to force an extended cavity laser into a single-longitudinal mode oscillation. A phase-matching bandwidth of 0.05 nm or less is described as being essential for efficient frequency doubling with commonly used second-harmonic-generation materials, such as potassium niobate. Again, careful tuning by temperature and other means appears necessary to maintain the required single mode operation, which is a prerequisite for this setup.

A less known and undiscussed problem is that of spectral distortions which may occur when a polarization-maintaining fiber is used for typical laser-grating configurations in fiber amplifier systems. Details are explained further below.

The main object of this invention is to devise a reliable laser source which emits light in an emission spectrum significantly smaller than the longitudinal laser mode separation and, at the same time, does not exhibit spectral distortions in polarization-maintaining fibers, and further yields substantially reduced mode-hopping noise.

Contrary to the known pump laser stabilization schemes as described in earlier patent applications EP 1 087 479 and GB 303271.1, the present invention uses a dominant, very long cavity together with a narrow grating reflector bandwidth which arrangement leads to a desired distribution of the modes. This long cavity is formed between the grating reflector and the laser back facet, whereby the reflectivities of the reflectors in-between are considered to be very small and thus negligible.

However, slight residual reflections act as small pertubations to the dominant mode field, influencing - and sometimes deteriorating - the performance of the laser source. In particular, residual reflections from the fiber lens add to reflections from the front-facet coating of the laser chip. The fiber-tip reflectivity can be taken into account by defining a modified front-facet reflectivity, $R_F$, in which the combined effect of both reflectors is incorporated. In the following, with respect to this invention the term front-facet reflectivity or $R_F$ denotes the combined front-facet reflectivity as defined here.

A further object is to provide a stable output without the need for an active temperature stabilizing element, especially for pump lasers in optical fiber communication systems.

A specific object is to avoid the above-mentioned detrimental mode hopping noise and spectral distortions in high power laser sources, i.e. laser sources with output powers of more than 100 mW, and still provide a stable output of such high power laser sources.

A further specific object is to provide an efficient laser source with an emission bandwidth of preferably less than 0.05 nm, without compromising low noise performance, i.e. for optimum phase matching in frequency doubling systems. A further object is to allow maximum flexibility for choosing the laser source's parameters without running into stability problems.

A still further object is to avoid any further complexity and keep the number of additional components of the laser source within a laser pumped optical amplifier to a minimum.

Patent application EP0991153 discloses a high power laser module comprising a laser diode with a high reflectivity back facet and a low reflectivity front facet, and an optical feedback medium with a reflectivity centered at the desired wavelength, with a FWHM of 2-3 nm, and reflectivity larger than the front facet reflectivity.

## Summary of the Invention

The invention is defined in claim 1. Embodiments of the invention are set out in the dependent claims.

To achieve the above objects, i.e. to obtain a stabilized laser pump source for applications requiring a narrow bandwidth, the present invention provides a novel laser source with at least one main external reflector providing a very long cavity and establishing a very high relative feedback, whereby this reflector has an extremely narrow reflectivity bandwidth at a given operating wavelength.

All additional reflectors in the path of the long cavity between the laser back facet and the main reflector are chosen to be as small as possible, e.g. the anti-reflection coatings on the laser diode and the fiber lens. The reflectivity of the main reflector is optimized by design for achieving a very high relative feedback.

In particular, the reflectivity bandwidth of the reflector, defined by the full-width-half-maximum (FWHM) bandwidth, is designed to be no greater than about 100 pm, preferably no greater than 50 pm.

Further, the long cavity is in the range of more than 0.5 m, preferably 2 m, so that in the order of 100 modes fit into the cavity at the operating wavelength. Even further, a (combined) front-facet reflectivity of less than 0.5 %, a diode-to-fiber coupling efficiency of about 75 %, and a relative feedback higher than 1, preferably higher than 30, are typical for a design according to the invention.

Also, such a design may allow the laser source to operate within the laser diode's locking range without the need for an active temperature stabilizing element.

In a preferred embodiment of the invention, the external reflector is a fiber Bragg grating having a uniform reflection characteristic, said grating being integrated in the optical fiber used for guiding the laser beam. This simplifies the manufacture and avoids the need for extra parts or components. Alternatively, other types of reflectors can be used, e.g. discrete optical interference filters.

In another embodiment of the invention, the shape of the reflection characteristic of the fiber Bragg grating can be linear, flat-top, or the shape resulting from a chirped and/or apodized filter design. This has the advantage of additional design flexibility. Moreover, an apodized grating may avoid lasing at a side-band maximum of the reflection characteristic instead of lasing at the Bragg wavelength.

In yet another embodiment, an electronic dither imposed by modulating the laser diode's injection current can be applied in addition and with respect to all previously mentioned embodiments. This would result in the advantage of further improved power stability.

## Brief Description of the Drawings

Preferred embodiments of the invention are described below with reference to the following schematic drawings. The drawings are provided to illustrate the invention and are not necessarily to scale.

Fig. 1        shows a schematic illustration of a stabilized laser source with a laser diode and a fiber guide with integrated Bragg grating;

Fig. 2        represents schematically the reflection spectrum of a fiber Bragg grating reflector with multiple modes of the long cavity;

Figs. 3a, 3b    shows a spectrum with distortions for fiber grating bandwidth wider than 1 nm (3a), and a spectrum with eliminated distortions for an FBG bandwidth of 20 pm (3b), using a polarization-maintaining fiber;

Figs. 4a, 4b    show graphs of the typical sawtooth-like power vs. current curve for a laser source with still excessive combined reflectivity of the anti-reflection coatings on laser diode's front facet and fiber lens; and

Figs. 5a, 5b    show graphs of the improved, smoother power vs. current curve for a laser source with substantially reduced distortions resuting from other reflectors than the laser diode's back facet and main reflector.

## Detailed Description

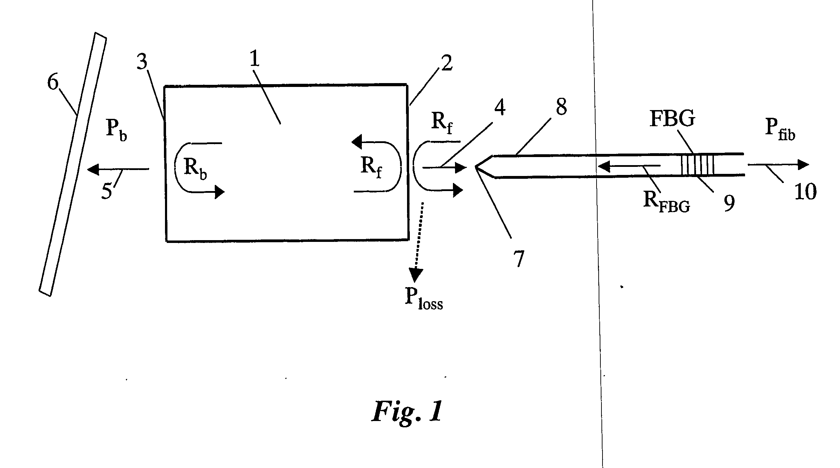

Fig. 1 shows the basic layout of a first and preferred embodiment according to the invention. A semiconductor laser diode 1, e.g. a high-power laser diode operating at a wavelength of approximately 980 nm, generates a laser beam 4 that is emitted predominantly from the front facet 2. At the back facet 3 with a reflectivity $R_b$, a low intensity laser light beam 5 with a power $P_b$ is also emitted, which beam is detected by a monitoring photodiode 6. As known in the art, the monitoring photodiode 6 converts the received light to a back facet monitoring (BFM) current for controlling the laser diode's injection current in a feed-back loop.

The laser beam 4 exiting the laser diode's front facet 2 is coupled into a suitable guide means 8, preferably an optical fiber, via a fiber lens 7 which focuses the laser beam 4 into the input end of the optical fiber 8. Within the fiber 8, an optical reflector 9, e.g. a fiber Bragg grating (FBG), is provided. The FBG may be fabricated by exposure to UV radiation having a periodic intensity along a piece of the optical fiber, as described e.g. by Raman Kashyap in "Fiber Bragg Gratings", Academic Press, 1999. A stabilized fiber exit beam 10 leaves the optical fiber 8 and is fed into a fiber amplifier, e.g. an erbium-doped fiber amplifier, or, into a device for second-harmonic-generation, not shown here.

In the following, the operation principle of a stabilized laser source using an external reflector, e.g. an FBG, is presented. As mentioned above, in a high-power semiconductor laser diode, the back facet 3 is coated with a highly reflective filter having a reflectivity $R_b$ at the design wavelength, whereas the front facet 2 is coated with a low-reflectivity filter in the form of an anti-reflection coating, having a reflectivity $R_f$ at the design wavelength. However, most of the laser light is emitted from the front facet 2 and is coupled into the optical fiber 8 via the fiber lens 7. The power coupling efficiency $\eta_C$ defines the proportion of light coupled into the optical fiber. Typical values of approximately 0.7 are achieved with mass production means, whereas a value of up to 0.9 may be achieved in a controlled laboratory environment. The laser light further propagates within the optical fiber towards the FBG which has a reflectivity $R_{FBG}$ at the design wavelength. The partial reflection of the laser light by the FBG into the laser diode thus creates feedback.

The feedback strength, also called the relative feedback $r_{FB}$, can be defined as

$$r_{FB} = \overline{\eta_C{}^2\, R_{FBG}\, (1\text{-}R_F)^2}/\, R_F \approx \eta_C{}^2\, R_{FBG}\, /\, R_F \ \text{for}\ R_F \!<\!< 1,$$

which reduces approximately to the ratio of the FBG's reflectivity (including the power coupling efficiency squared) and the laser's front facet reflectivity $R_F$ if the latter is much smaller than one. The term $\eta C^2$ may be considered a constant k for a given arrangement and defined materials.

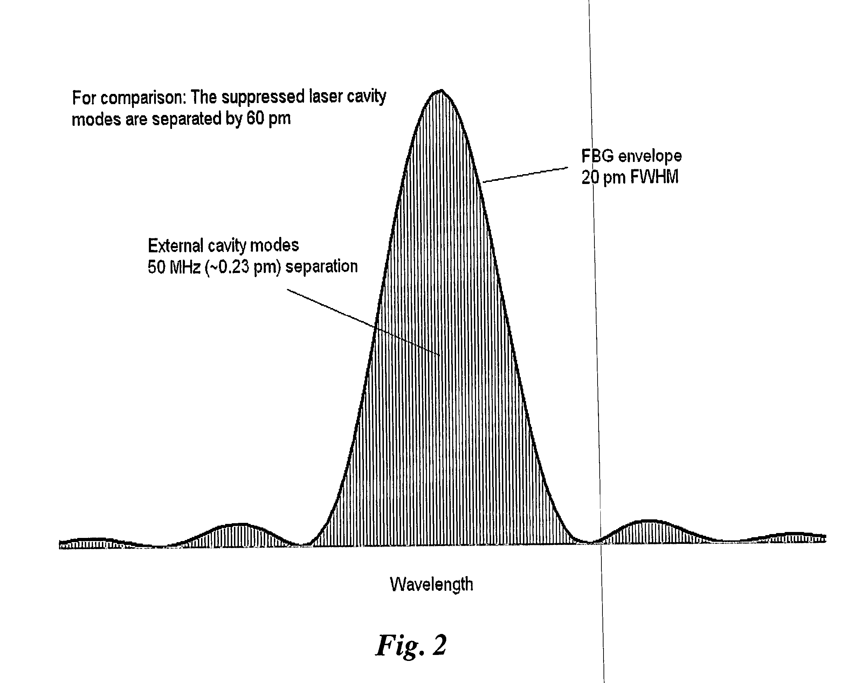

According to the invention, a laser source with a $R_F$ of the laser diode's front facet 2 lower than 0.1 % is wavelength-stabilized by an FBG or other external reflector with a very narrow bandwidth. The reflectivity of this external reflector is $R_{FBG}$. Further, the distance between the laser diode's back facet 3 and the external reflector 9, e.g. an FBG, is very large, much larger than 10 cm, and tailored in such a way that multiple modes of the main cavity formed between reflectors 3 and 9, fit into this bandwidth as shown in Fig. 2.

Fig. 2 shows schematically the formation of the desired multimode band spectrum, consisting of external cavity modes selected by the envelope function provided by the external reflector 9, e.g. an FBG, with a very narrow bandwidth. Other unwanted spectral components, resulting from cavities formed between other reflectors are not shown.

With a very high reflector reflectivity $R_{FBG}$, as compared to the reflectivity $R_F$ of the laser diode's front facet 2, the modes of the "very long cavity" between the external reflector 9 and the back facet 3 of the laser diode 1 become dominant over the modes within the laser diode's cavity, i.e. between the laser diode's front facet 2 and its back facet 3. This differentiates the design according to the present invention from known EDFA-pump-laser stabilization schemes as disclosed in EP 1 087 479 and GB 303271.1, assigned to the assignee of the present invention.

Reflections from the laser diode's front facet coating might still generate a weak laser longitudinal mode field, which then produces unwanted distortions to the mode field generated by the very long cavity. However, with proper choice of the applicable parameters, the distortions may be averaged out by the multi-mode nature of the very long cavity and mode-hopping noise is successfully suppressed, at least in a frequency range relevant to the discussed applications (< 2 MHz). Of particular importance in the preferred embodiment is the reduction of the laser front reflectivity to below 0.1 % and that a long external cavity of 2 m enables the onset of more than 100 (long cavity) modes within a small FBG bandwidth of 20 pm. This is a clear improvement also over any so-called fiber grating laser systems (FGL systems), as described in the Furukawa paper mentioned above, as well as over any other single mode selection scheme.

Further, using a polarization maintaining (PM) fiber in typical pump laser grating configurations, i.e. configurations wherein the FBG usually has a typical bandwidth of 1 nm, can introduce spectral distortions. Here an alignment of the fiber axes relative to transverse-electric-polarized (TE-polarized) laser output with a precision of the order of 5° is necessary to obtain a well-defined and stable spectrum. If the fiber axes are misaligned, spectral distortions, in the sense of spectral holes, and instabilities can occur.

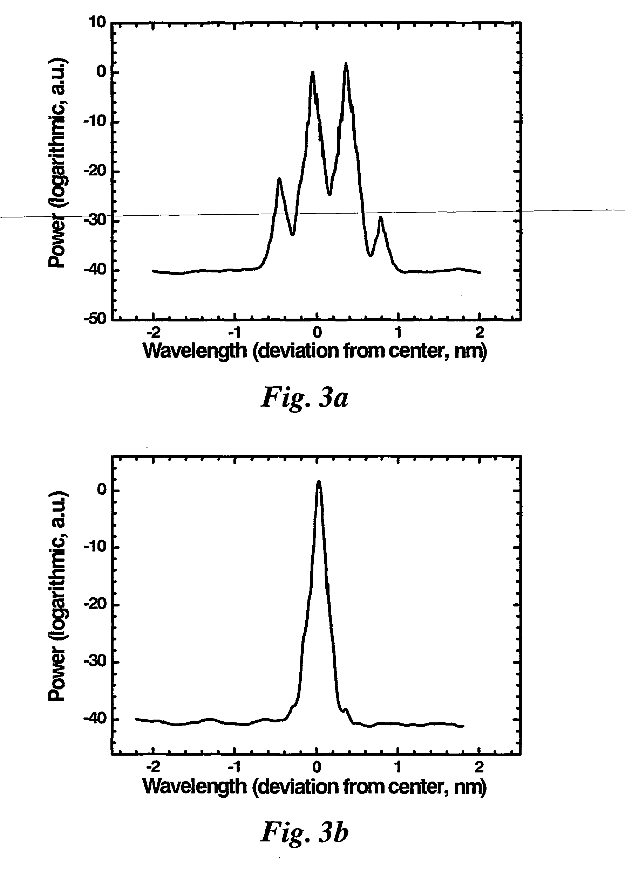

Fig. 3a shows an example of such a spectrum, when a grating bandwidth wider than 1 nm is used. The spectrum shows multiple peaks, and, moreover, its shape can vary with changing external conditions and time. The shape of this spectrum can be explained by the fast variation of the effective feedback with wavelength, the reason of which is the built-in high birefringence of a polarization-maintaining fiber. In a typical fiber of this type, a phase variation on the order of $\pi$ occurs within a wavelength interval of 0.5 nm if the FBG is separated by 2 m from the laser. The effective feedback varies with the same periodicity. Since modes having a phase shift close to a multiple of $\pi$ (0, $\pi$, 2$\pi$, 3$\pi$, ..) experience

EP 1 745 532 B1

a higher effective feedback than modes having a phase shift close to π/2, 3π/2, 5π/2, ... , the former will oscillate preferentially, whereas the latter will be suppressed despite the fact that their wavelength is located within the reflection band of the FBG. Such spectral distortion can be eliminated by using FBGs of narrow bandwidth, much smaller than the wavelength interval required to acquire a π phase shift in the fiber.

In Fig. 3b, the spectrum of the same device as in Fig. 3a is shown, however now stabilized by an FBG having a bandwidth of less than 0.05 nm. This spectrum is stable in shape and time. Therefore, the use of such narrow bandwidth FBGs is an advantage whenever the FBG is written into a polarization-maintaining fiber, as the tolerances for the alignment of the axes can be relaxed to 15-20°.

To avoid any confusion, it should be noted that the observed phenomenon is not related to commonly known polarization noise or birefringence noise issues.

According to the invention, these spectral distortions can be eliminated by using a reflector 9, e.g. an FBG, with an FWHM bandwidth being small compared to the period of the modulated feedback. In other words, with an FWHM bandwidth of 0.1 nm or less, the spectral instabilities can be substantially eliminated.

In addition, such a narrow bandwidth of the reflector 9 allows for a higher density of pump wavelengths in pump multiplexing schemes, and also is an advantage in frequency doubling applications.

Typical parameters for a fabricated structure according to the invention are:

- 20 pm for the grating FWHM bandwidth;
- 2 m Bragg grating distance, which means that about 100 modes fit into the external cavity into a grating bandwidth of 20 pm;
- < 0.1 % reflectivity $R_F$ of the laser front facet coating;
- a relative feedback of 10, at least higher than 1;
- 75 % typical laser diode-to-fiber coupling efficiency.

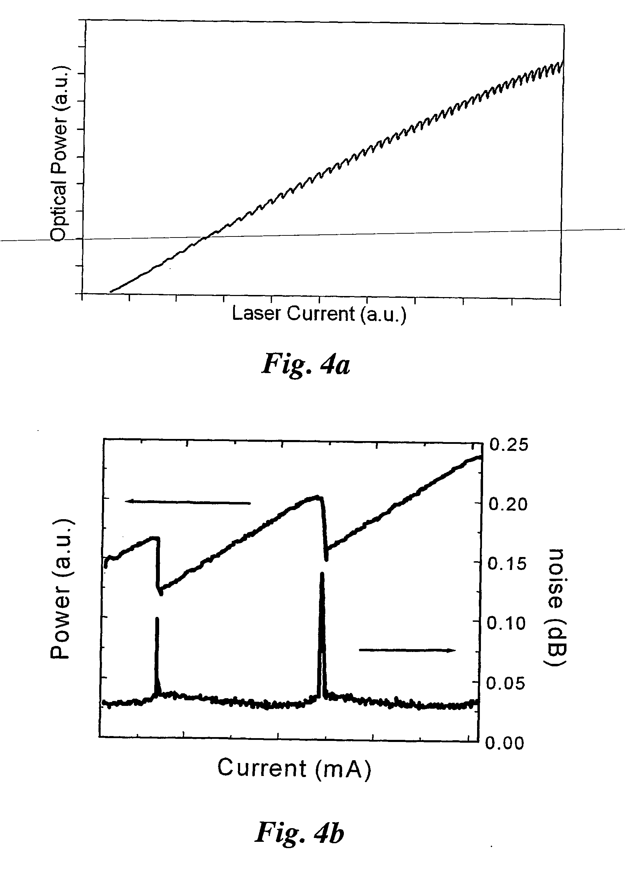

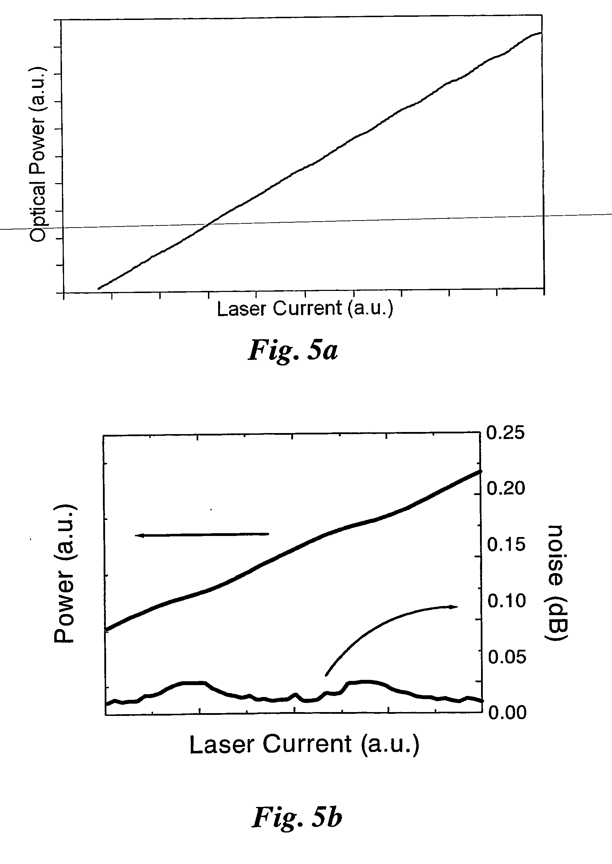

Two devices have been investigated with the parameters above. A noise reduction from 0.15 dB to less than 0.035 dB was achieved at a measurement bandwidth of less than 2 MHz, as can be seen from the Figs. 4a, 4b and 5a, 5b, described in the following.

The noise, commonly specified for pump lasers as power variation ($P_{VAR}$ in dB) is defined as

$$P_{VAR} = -10\log\left(\frac{P_{AV} - (P_{max} - P_{min})}{P_{AV}}\right)$$

at a temperature and fixed drive current. The measurement is done in the frequency range of less than 2 MHz over a sampling time of 5 seconds, during which the maximum, minimum, and average powers denoted as $P_{max}$, $P_{min}$ and $P_{AV}$, respectively, are recorded. This procedure is repeated for each operating current step.

Figs. 4a/b shows a rippled power-versus-current curve of a device which exhibits strong mode hopping effects, similar to those in the Furukawa paper. Strong noise spikes can be seen in Fig. 4b. The sawtooth-shaped power-versus-current curve is produced by unwanted longitudinal laser cavity modes cycling through the FBG envelope with increasing current, revealing that the lasers front facet reflectivity is still higher than 0.1 %.

Figs. 5a/b demonstrate the improvement obtained with laser front facet reflectivities lower than 0.1 %. A much smoother power-versus-current curve is seen in Fig. 5a. Fig. 5b reveals that mode hopping noise is substantially suppressed with considerably reduced ripples present in the power-versus-current characteristic.

Some modifications of the above described embodiments may be adopted from the devices described in earlier patent applications EP 1 087 479 and GB 303271.1, mentioned above. One useful modification is to employ an apodized grating, as already mentioned above.

A further meaningful modification is to provide a plurality of gratings, of which at least one should be integrated within the guide means. This has the advantage of further reduced low-frequency power fluctuations, as described in patent application WO 01/22544 A1.

If a predetermined filter function is required, the grating or gratings may be structured to exhibit the required or useful non-uniform reflection characteristic. Thus, if filter functions of flat-top shape or linear shape are beneficial for specific applications, these may be generated by appropriately modifying the grating or gratings, as described in EP 1 087 479.

Similarly, the grating may be executed as a chirped grating resulting in a preselected chirped filter function shape, as mentioned above.

Where suppressed side-band maxima, e.g. for non-temperature stabilized operation, are required, the grating may be structured as apodized grating resulting in the required filter function. The performance improvement with apodized gratings are described in EP 1 087 479.

Naturally, several of the functional modifications of the grating or gratings may be combined so that, e.g. at least one of the gratings may be chirped and apodized, resulting in a preselected chirped filter function shape with suppressed side-band maxima.

A different modification is the use of an electronic dither, preferably generated by superimposing a suitably dithered current on the injection current of the laser diode. Such a dither generally improves the power stability of the laser source.

Particularly preferred for the laser source according to the invention is the well-known InGaAs quantum well laser diode.

The person skilled in the art may further include means for directing the laser beam into an optical fiber, in particular beam collimating or focusing means attached to or integrated into said optical fiber. A preferred use of a laser source according to the invention is - as already mentioned - in EDFA applications. In this application, the narrower bandwidth, compared to state-of-the-art designs, allows for a higher density for pump wavelength multiplexing to provide more power to the EDFA, and at the same time yields improved power stability.

Another use of a laser source according to the invention is in frequency doubling devices. Such devices, however of a different design, are described in the above-mentioned Kozlovsky paper "Blue Light Generation by Resonator-enhanced Frequency Doubling of an Extended-cavity Diode Laser".

In such a device according to the present invention, the generated radiation is fed into an independently controlled cavity with a second harmonic generation (SHG) crystal. Such nonlinear materials have a narrow acceptance bandwidth, which suits the narrow bandwidth generated by the invented laser source. Thus, the narrow-bandwidth laser source according to the invention, together with an SHG crystal, may be used as a robust replacement of aircooled argon-ion lasers at 488 nm for biomedical applications. As well known to the person skilled in the art, such argon-ion lasers are bulky devices, consume substantial amounts of power, and have a typical lifetime of only about 5000 hours, so that a blue laser source according to the invention compares very favourably. In addition, it appears easier to satisfy the stringent noise requirements usually connected with biomedical applications like DNA sequencing and cytometry.

In principle, any of the various embodiments described above will look similar or even identical to the schematic structure shown in Fig. 1, and a person skilled in the art should have no problem to determine and vary the technical details, in particular the spatial arrangement. As clearly described, the important aspects of the invention are the unusual selection of various dimensions contrary to the state-of-the-art. These unusual dimensions provide the desired improved function of the present invention.

## Claims

1. A high power laser source of more than 100 mW for generating a stable multimode exit beam (10) at a desired wavelength, said laser source comprising a laser diode (1) and guide means (8) for conducting a laser beam (4), said guide means (8) including at least one external reflector (9) with a reflectivity $R_{FBG}$ centered at said desired wavelength, said laser diode (1) having a given mode separation and having a front facet (2) with a low reflectivity $R_F$ and a back facet (3) with a high reflectivity $R_B$, said reflectivity $R_F$ being smaller than said reflectivity $R_{FBG}$, *characterized in that*

   - said external reflector (9) has a full-width-half-maximum (FWHM) bandwidth of less than 0.1 nm, said bandwidth being smaller than said given mode separation in said laser diode (1),
   - said external reflector (9) forms a dominant long cavity of at least 0.5 m with said back facet (3) of said laser diode (1), encompassing several tens of modes at said desired wavelength, and
   - said reflectivities $R_{FBG}$ and $R_F$ are selected to achieve a predetermined relative feedback of

   $$r_{FB} = \eta^2 \cdot R_{FBG} / R_F > 10,$$

   $\eta$ being the coupling efficiency to said guide means (8).

2. The laser source according to claim 1, *wherein* the full-width-half-maximum (FWHM) bandwidth of the external reflector (9) is less than 50 pm, preferably equal to or less than 20 pm.

3. The laser source according to claim 1, *wherein* the long cavity has a length of at least 2 m.

4. The laser source according to claim 1, *wherein*
the reflectivity $R_F$ of the laser's front facet (2) is equal or less than 0.5%.

5. The laser source according to claim 1, *wherein*
the coupling efficiency $\eta$ is between 0.5 and 0.9, preferably between 0.65 and 0.85.

6. The laser source according to one of the preceding claims, *wherein*
the guide means (8) includes a waveguide consisting of or comprising silicon nitride ($Si_3N_4$), silica ($SiO_2$), or silicon (Si).

7. The laser source according to one of the preceding claims, *wherein*
the external reflector (9) is a grating, in particular a fiber Bragg grating, integrated within the guide means (8).

8. The laser source according to claim 7, *wherein*
the grating is an apodized grating.

9. The laser source according to claim 7, *wherein*
two or more gratings (9) are provided, at least one of them integrated within the guide means (8).

10. The laser source according to claim 7, wherein
the grating exhibits a non-uniform reflection characteristic, in particular a filter function with a linear shape or a flat-top shape.

11. The laser source according to claim 7, wherein
the grating is a chirped grating or an apodized grating or a a chirped and apodized grating, resulting in a filter function with suppressed side-band maxima.

12. The laser source according to claim 1, wherein
an electronic dither is superimposed on an injection current of the laser diode for improving the power stability of the laser exit beam.

13. The laser source according to claim 1, *wherein*
the laser is a semiconductor diode laser, in particular a 980nm InGaAs strained quantum well diode laser.

14. The laser source according to claim 1, wherein
the laser guide means comprises an optical fiber.

15. The laser source according to claim 1, wherein
the guide means includes means for directing the laser beam into an optical fiber, in particular beam collimating or focusing means attached to or integrated into an optical fiber.

16. Use of a laser source according to any of the preceding claims as pump laser for a fiber amplifier, in particular an erbium-doped fiber amplifier.

17. Use of a laser source according to any of the claims 1 to 15 for a frequency doubling system, in particular a blue laser system.

18. A fiber amplifier for optical communication purposes, in particular an erbium-doped fiber amplifier, including a laser source as pump laser according to at least one of the claims 1 to 15.

19. A blue laser system with a frequency doubling arrangement, including a laser source according to at least one of the claims 1 to 15.

**Patentansprüche**

1. Hochleistungslaserquelle mit mehr als 100 mW zum Generieren eines stabilen Multimode-Austrittsstrahls (10) mit einer gewünschten Wellenlänge, wobei die Laserquelle eine Laserdiode (1) und Führungsmittel (8) zum Leiten eines Laserstrahls (4) umfasst, wobei die Führungsmittel (8) mindestens einen externen Reflektor (9) mit einem um die gewünschte Wellenlänge zentrierten Reflexionsvermögen $R_{FBG}$ einschließen, wobei die Laserdiode (1) einen gegebenen Modenabstand und eine vordere Facette (2) mit einem niedrigen Reflexionsvermögen $R_F$ und eine hintere Facette (3) mit einem hohen Reflexionsvermögen $R_B$ aufweist, wobei das Reflexionsvermögen $R_F$ kleiner als das Reflexionsvermögen $R_{FBG}$ ist, **dadurch gekennzeichnet, dass**

- der externe Reflektor (9) eine Bandbreite der vollen Halbwertsbreite (FWHM) von weniger als 0,1 nm aufweist, wobei die Bandbreite kleiner als der gegebene Modenabstand in der Laserdiode (1) ist,
- der externe Reflektor (9) einen dominanten langen Resonator von mindestens 0,5 m mit der hinteren Facette (3) der Laserdiode (1) bildet, der mehrere -zig Moden bei der gewünschten Wellenlänge umfasst, und
- die Reflexionsvermögen $R_{FBG}$ und $R_F$ ausgewählt sind, um eine festgelegte relative Rückkopplung von

$$r_{FB} = \eta^2 \cdot R_{FBG}/R_F > 10,$$

zu erreichen, wobei $\eta$ die Kopplungseffizienz zu dem Führungsmittel (8) ist.

2. Laserquelle nach Anspruch 1, wobei die Bandbreite der vollen Halbwertsbreite (FWHM) des externen Reflektors (9) weniger als 50 pm, vorzugsweise gleich oder weniger als 20 pm beträgt.

3. Laserquelle nach Anspruch 1, wobei der lange Resonator eine Länge von mindestens 2 m hat.

4. Laserquelle nach Anspruch 1, wobei das Reflexionsvermögen $R_F$ an der vorderen Facette (2) des Lasers gleich oder kleiner als 0,5 % ist.

5. Laserquelle nach Anspruch 1, wobei die Kopplungseffizienz $\eta$ zwischen 0,5 und 0,9, vorzugsweise zwischen 0,65 und 0,85 beträgt.

6. Laserquelle nach einem der vorhergehenden Ansprüche, wobei das Führungsmittel (8) einen Wellenleiter einschließt, der Siliciumnitrid ($Si_3N_4$), Siliciumdioxid ($SiO_2$) oder Silicium (Si) umfasst oder daraus besteht.

7. Laserquelle nach einem der vorhergehenden Ansprüche, wobei der externe Reflektor (9) ein Gitter, insbesondere ein Bragg-Fasergitter ist, das in das Führungsmittel (8) integriert ist.

8. Laserquelle nach Anspruch 7, wobei das Gitter ein apodisiertes Gitter ist.

9. Laserquelle nach Anspruch 7, wobei zwei oder mehr Gitter (9) bereitgestellt werden, von denen mindestens eines in das Führungsmittel (8) integriert ist.

10. Laserquelle nach Anspruch 7, wobei das Gitter eine ungleichförmige Reflexionscharakteristik zeigt, insbesondere eine Filterfunktion mit einer linearen Form oder einer Tafelform.

11. Laserquelle nach Anspruch 7, wobei das Gitter ein gechirptes Gitter oder ein apodisiertes Gitter oder ein gechirptes und anodisiertes Gitter ist, das zu einer Filterfunktion mit unterdrückten Seitenbandmaxima führt.

12. Laserquelle nach Anspruch 1, wobei ein Injektionsstrom der Laserdiode mit einer elektronischen Überlagerungsschwingung überlagert wird, um die Leistungsstabilität des Laseraustrittsstrahls zu verbessern.

13. Laserquelle nach Anspruch 1, wobei der Laser ein Halbleiterdiodenlaser ist, insbesondere ein gespannter 980 nm InGaAs-Quantentopf-Diodenlaser

14. Laserquelle nach Anspruch 1, wobei das Laser-Führungsmittel eine optische Faser umfasst.

15. Laserquelle nach Anspruch 1, wobei das Führungsmittel Mittel zum Lenken des Laserstrahls in eine optische Faser einschließt, insbesondere Strahlkollimations- oder -fokussiermittel, die an einer optischen Faser befestigt oder in diese integriert sind.

**16.** Verwendung einer Laserquelle nach einem der vorhergehenden Ansprüche als Pumplaser für einen Faserverstärker, insbesondere einen Erbium-dotierten Faserverstärker.

**17.** Verwendung einer Laserquelle nach einem der Ansprüche 1 bis 15 für ein Frequenzverdopplungssystem, insbesondere ein blaues Lasersystem.

**18.** Faserverstärker für optische Kommunikationszwecke, insbesondere ein Erbium-dotierter Faserverstärker, der eine Laserquelle nach mindestens einem der Ansprüche 1 bis 15 als Pumplaser einschließt.

**19.** Blaues Lasersystem mit einer Frequenzverdopplungsanordnung, das eine Laserquelle nach mindestens einem der Ansprüche 1 bis 15 einschließt.

**Revendications**

**1.** Source laser de puissance de plus de 100 mW destinée à générer un faisceau de sortie multimode stable (10) à une longueur d'onde souhaitée, ladite source laser comprenant une diode laser (1) et un moyen de guidage (8) destiné à acheminer un faisceau laser (4), ledit moyen de guidage (8) incluant au moins un réflecteur externe (9) présentant une réflectivité $R_{FBG}$ centrée au niveau de ladite longueur d'onde souhaitée, ladite diode laser (1) présentant une séparation de mode donnée et présentant une facette avant (2) présentant une faible réflectivité $R_F$ et une facette arrière (3) présentant une réflectivité élevée $R_B$, ladite réflectivité $R_F$ étant inférieure à ladite réflectivité $R_{FBG}$, *caractérisée en ce que*

- ledit réflecteur externe (9) présente une bande passante de pleine largeur à mi-hauteur (FWHM) de moins de 0,1 nm, ladite bande passante étant inférieure à ladite séparation de mode donnée dans ladite diode laser (1),
- ledit réflecteur externe (9) forme une cavité allongée dominante d'au moins 0,5 m avec ladite facette arrière (3) de ladite diode laser (1), englobant plusieurs dizaines de modes au niveau de ladite longueur d'onde souhaitée, et
- lesdites réflectivités $R_{FBG}$ et $R_F$ sont sélectionnées pour obtenir une rétroaction relative prédéterminée de

$$r_{FB} = \eta^2 \cdot R_{FBG} / R_F > 10,$$

$\eta$ étant l'efficacité de couplage audit moyen de guidage (8).

**2.** Source laser selon la revendication 1, *dans laquelle* la bande passante de pleine largeur à mi-hauteur (FWHM) du réflecteur externe (9) est de moins de 50 pm, de préférence égale ou inférieure à 20 pm.

**3.** Source laser selon la revendication 1, *dans laquelle* la cavité allongée présente une longueur d'au moins 2 m.

**4.** Source laser selon la revendication 1, *dans laquelle* la réflectivité $R_F$ de la facette avant de laser (2) est inférieure ou égale à 0,5%.

**5.** Source laser selon la revendication 1, *dans laquelle* l'efficacité de couplage $\eta$ est comprise entre 0,5 et 0,9, de préférence entre 0,65 et 0,85.

**6.** Source laser selon l'une des revendications précédentes, *dans laquelle*
le moyen de guidage (8) inclut un guide d'onde constitué de ou comprenant du nitrure de silicium ($Si_3N_4$), de la silice ($SiO_2$), ou du silicium (Si).

**7.** Source laser selon l'une des revendications précédentes *dans laquelle*
le réflecteur externe (9) est un réseau optique, en particulier un réseau optique de Bragg à fibre, intégré à l'intérieur du moyen de guidage (8).

**8.** Source laser selon la revendication 7, *dans laquelle*
le réseau optique est un réseau optique à apodisation.

**9.** Source laser selon la revendication 7, *dans laquelle*
deux réseaux optiques ou plus (9) sont fournis, au moins un d'entre eux étant intégré à l'intérieur du moyen de guidage (8).

**10.** Source laser selon la revendication 7, dans laquelle
le réseau optique présente une caractéristique de réflexion non uniforme, en particulier une fonction de filtre présentant une forme linéaire ou une forme à sommet plat.

**11.** Source laser selon la revendication 7, dans laquelle
le réseau optique est un réseau optique à longueur d'onde répartie ou un réseau optique à apodisation ou un réseau optique à apodisation et à longueur d'onde répartie, résultant en une fonction de filtre avec des maxima de bande latérale supprimés.

**12.** Source laser selon la revendication 1, dans laquelle
une activation électronique est superposée sur un courant d'injection de la diode laser afin d'améliorer la stabilité de puissance du faisceau de sortie laser.

**13.** Source laser selon la revendication 1, *dans laquelle*
le laser est un laser de diode à semi-conducteur, en particulier un laser de diode à puits quantique contraint de InGaAs à 980 nm.

**14.** Source laser selon la revendication 1, dans laquelle
le moyen de guidage de laser comprend une fibre optique.

**15.** Source laser selon la revendication 1, dans laquelle
le moyen de guidage inclut un moyen destiné à orienter le faisceau laser jusque dans une fibre optique, en particulier un moyen de concentration ou de collimation fixé à ou intégré dans une fibre optique.

**16.** Utilisation d'une source laser selon l'une quelconque des revendications précédentes en tant que laser à pompe destiné à un amplificateur à fibre, en particulier un amplificateur à fibre dopée à l'erbium.

**17.** Utilisation d'une source laser selon l'une quelconque des revendications 1 à 15 pour un système de doublage de fréquence, en particulier un système laser bleu.

**18.** Amplificateur à fibre à des fins de communication optique, en particulier un amplificateur à fibre dopée à l'erbium, incluant une source laser en tant que laser à pompe selon au moins une des revendications 1 à 15.

**19.** Système laser bleu présentant un agencement de doublage de fréquence, incluant une source laser selon au moins une des revendications 1 à 15.

*Fig. 1*

EP 1 745 532 B1

For comparison: The suppressed laser cavity
modes are separated by 60 pm

FBG envelope
20 pm FWHM

External cavity modes
50 MHz (~0.23 pm) separation

Wavelength

*Fig. 2*

*Fig. 3a*

*Fig. 3b*

**Fig. 4a**

**Fig. 4b**

**Fig. 5a**

**Fig. 5b**

## REFERENCES CITED IN THE DESCRIPTION

### Patent documents cited in the description

- US 5563732 A, Erdogan
- US 5715263 A, Ventrudo
- EP 1087479 A
- GB 303271 A
- EP 0991153 A
- WO 0122544 A1

### Non-patent literature cited in the description

- **HASHIZUME et al.** Mode Hopping Control and Lasing Wavelength Stabilization of Fiber Grating Lasers. *Furukawa Review, No. 20,* 2001
- **KOZLOVSKY et al.** Blue Light Generation by Resonator-enhanced Frequency Doubling of an Extended-cavity Diode Laser. *Applied Physics Letters,* 1994
- **RAMAN KASHYAP.** Fiber Bragg Gratings. Academic Press, 1999